# EUROPÄISCHE PATENTANMELDUNG

(11) **EP 0 545 391 A1**
(43) Veröffentlichungstag der Anmeldung: **09.06.1993**
(21) Anmeldenummer: 92120583.7
(22) Anmeldetag: 02.12.1992
(51) Int. Cl.: H01L 41/08

(54) **Aktuator aus ferroelektrischen Keramikscheiben**

(30) Priorität: 05.12.1991 DE 4140107
(71) Anmelder: Hoechst CeramTec Aktiengesellschaft, D-95100 Selb (DE)
(72) Erfinder: Berthold, Heinrich, W-8521 Aurachtal (DE); Ullherr, Fritz, W-8560 Lauf (DE); Helke, Günter, Dr., W-8560 Lauf (DE)
(74) Vertreter: Hoffmann, Peter, Dipl.-Chem.

(57) **Zusammenfassung**

Bei dem Aktuator aus ferroelektrischen Keramikscheiben sind die Keramikscheiben, die beidseitig mit einer elektrisch leitfähigen Schicht versehen sind, miteinander verklebt und mit elektrischen Zuleitungen verbunden. Die leitfähigen Schichten (2) der einzelnen Scheiben (1) sind auf der Vorder- und Rückseite der Scheiben (1) mit jeweils einer um 180° gegeneinander versetzt angeordneten Isolierung (3) als Randzone versehen. Dabei liegen die Isolierungen (3) benachbarter Scheiben (1) übereinander. Den Isolierungen (3) auf der einen Seite liegen bis an die Kante reichende leitfähige Schichten (2) (Elektroden) auf der anderen Seite der Scheibe gegenüber.

## Beschreibung

Die Erfindung betrifft einen Aktuator aus ferroelektrischen Keramikscheiben, bei dem die beidseitig mit einer elektrisch leitfähigen Schicht versehenen Keramikscheiben miteinander verklebt und mit externen elektrischen Zuleitungen verbunden (parallel geschaltet) sind.

Unter ferroelektrischer Keramik soll sowohl piezoeletrische als auch elektrostriktive Keramik verstanden werden. Aktuatoren aus ferroelektrischer Keramik kommen in zunehmendem Maße als Antriebselemente in der Mikrosystemtechnik zum Einsatz für die Feinpositionierung im Mikrometerbereich bis etwa 100 µm. Die Wirkung solcher Aktuatoren aus ferroelektrischer Keramik beruht darauf, daß einzelne Platten oder Scheiben aus ferroelektrischer Keramik so zusammengefügt werden, daß sie mechanisch in Reihe und elektrisch parallel geschaltet sind. Es entsteht ein Platten- bzw. Scheibenstapel, der bei Anlegen einer Spannung eine Deformation erfährt, die der Betriebsspannung und der Anzahl der Elemente proportional ist. Die elektrische Parallelschaltung der Elemente des Stapels erfordert eine externe Verbindung der internen Elektroden gleicher Polarität. Dafür wurden bisher zwischen einander benachbarten Elektroden Metallfolien oder -gewebe gelegt und mit den Elektroden verklebt. Wesentlich dabei ist, daß die Metalleinlagen und die Klebefugen hinreichend dünn sind, um den Anteil der ferroelektrisch nicht aktiven Masse im Stapel zu minimieren, den elektrischen Kontakt zwischen benachbarten Elektroden zu gewährleisten und im Falle einer mechanischen Belastung bei Betrieb zusätzliche Nachgiebigkeiten zu eliminieren.

Solche Aktuatoren sind aus der DE-A-33 30 538 bekannt. Bei dem aus piezokeramischen Platten hergestellten Paket sind die als Elektroden vorgesehenen Oberflächenmetallisierungen zur jeweils gemeinsamen Kontaktierung um jeweils eine Plattenkante auf die jeweilige seitliche Kantenfläche herumgezogen und dort untereinander mit einem angelöteten Metallnetz verbunden.

Nach der DE-A-40 14 526 ist ein Verfahren zum Herstellen eines Stapels von piezokeramischen Scheiben bekannt. Danach werden auf den Scheiben nach dem Sputterverfahren beidseitig bis an den Rand reichende Elektroden abgeschieden und unter einem definierten Druck unter Verwendung eines Klebers mit niedriger Viskosität nacheinander zu einem Stapel zusammengefügt. Durch abschließende Überschichtung von Randkontaktflächen nach dem Sputterverfahren werden die für die elektrische Parallelschaltung der einzelnen Scheiben erforderlichen Anschlüsse hergestellt.

Problematisch bei den bekannten Aktuatoren sind die Spannungszuführung zu den einzelnen Scheiben und die Verteilung der Deformation über den Querschnitt bei anliegender Spannung des Aktuators. Hier will die Erfindung Abhilfe schaffen.

Die Aufgabe wird durch einen Aktuator gelöst, bei dem die leitfähigen Schichten der einzelnen Scheiben auf der Vorder- und Rückseite der Scheiben dieser Isolationsgrund, aber mit jeweils einer um 180° gegeneinander versetzt angeordneten partiellen Isolierung als Randzone versehen sind, wobei die Isolierungen benachbarter Scheiben übereinander liegen und den Isolierungen auf der einen Seite bis auf die Kante reichende leitfähige Schichten auf der anderen Seite der Scheibe gegenüberliegen.

Die Keramikscheiben können im Bereich der Isolierungen mit Ausnehmungen versehen sein, die halbkreisförmig ausgebildet sind und bei denen die Isolierung konzentrisch um die Ausnehmung angeordnet ist.

Die Vorteile der Erfindung sind im wesentlichen darin zu sehen, daß im Verbund mit der bis auf die Ausnehmung an die Kante der Scheibe reichenden Metallisierung von Elektrode und Gegenelektrode eine besonders homogene Verteilung der Deformation über den Querschnitt des Aktuator resultiert und die externe elektrische Verbindung aller Scheiben durch je eine durchgehende Leiterbahn erfolgen kann.

Im folgenden wird die Erfindung anhand von lediglich einen Ausführungsweg darstellender Zeichnung näher erläutert.

Es zeigt
Figur 1 a/b die Vorder- und Rückseite einer ferroelektrischen Scheibe,
Figur 2 den Aktuator mit Scheiben gemäß Figur 1 im Schnitt und
Figuren 3 a/b - 5 a/b alternative Ausführungsformen von Figur 1.

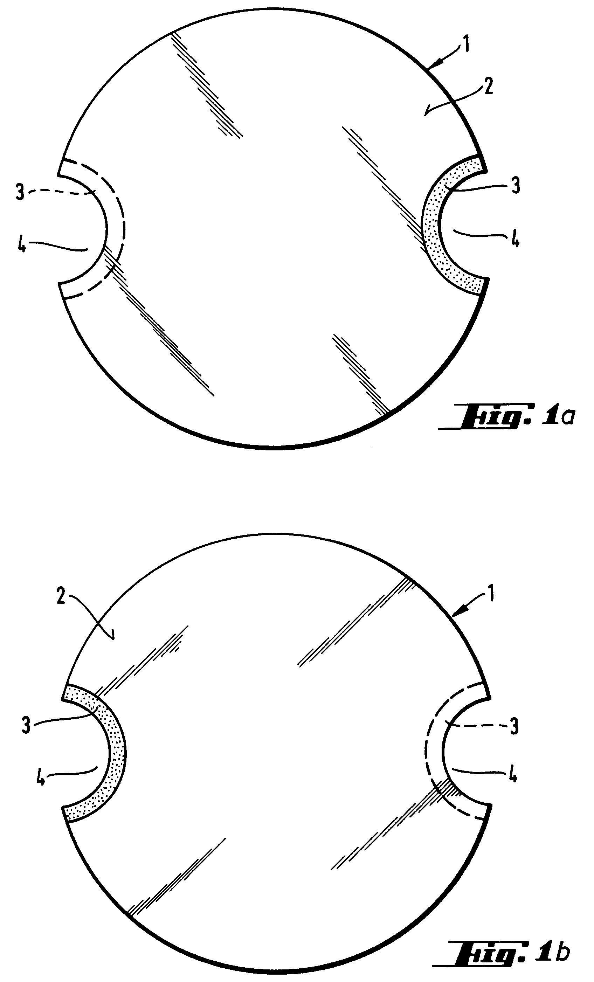

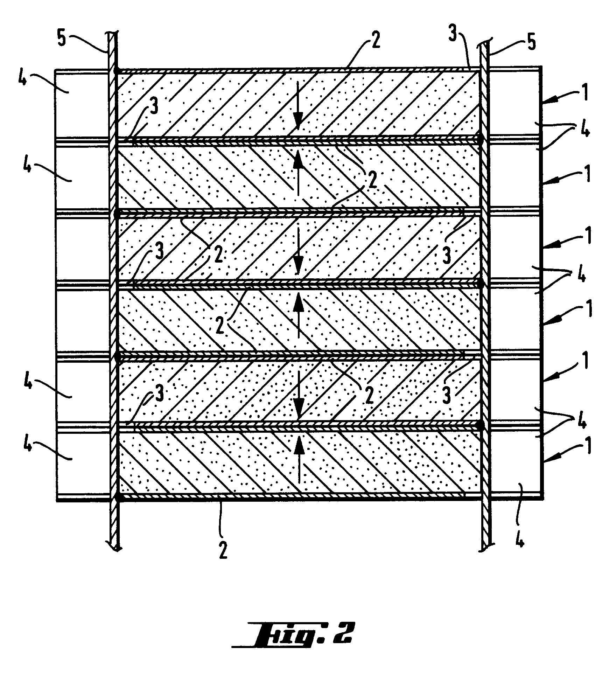

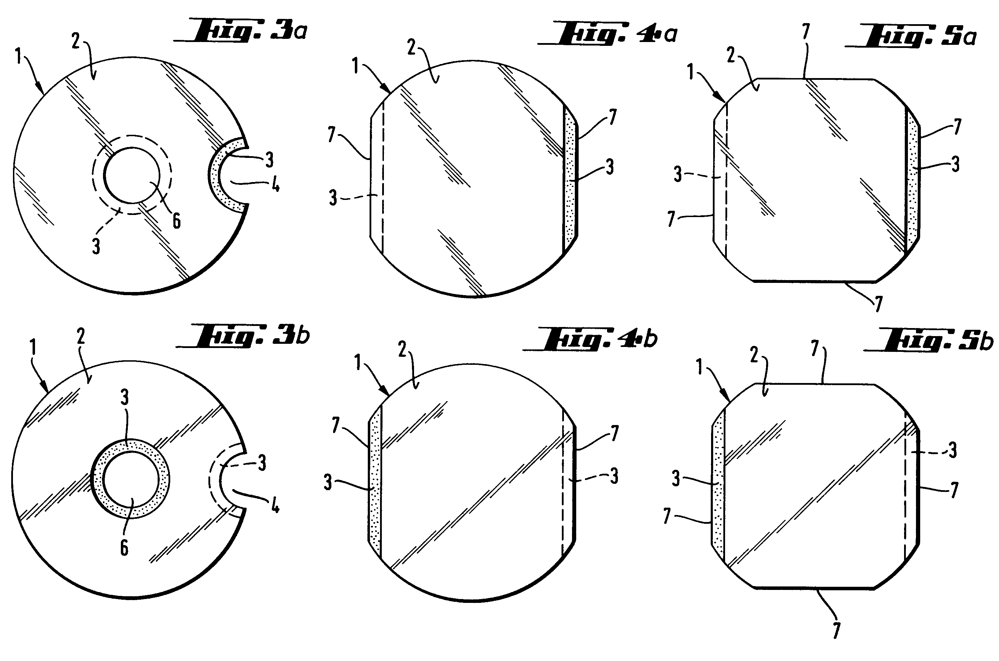

Bei dem Aktuator aus kreisrunden ferroelektrischen Scheiben 1 sind die Keramikscheiben 1 auf beiden Seiten nahezu vollständig mit einer elektrisch leitfähigen Schicht 2, einer Metallisierung versehen und miteinander verklebt. Jede elektrisch leitfähige Schicht 2 ist mit einer Isolierung 3 als Randzone versehen, wobei die Isolierungen 3 einer Scheibe 1 um vorzugsweise 180° versetzt und spiegelbildlich angeordnet sind. Die Scheiben 1 werden so gestapelt, daß die Isolierungen 3 benachbarter Scheiben 1 übereinander zu liegen kommen. Die Scheiben 1 können mit 2 kreisförmigen Ausnehmungen 4 versehen sein, um die jeweils eine Isolierung 3 konzentrisch angeordnet ist. Andere Formen der Ausnehmungen, z.B. Sekanten 7 (Figuren 4 a/b und 5 a/b) sind ebenfalls möglich. Bei der alternativen Ausführungsform gemäß Figur 3 a/b ist eine halbkreisförmige Ausnehmung 4 mit einer zentrisch angeordneten Bohrung 6 kombiniert. Die elektrischen Zuleitungen zu den einzelnen leitfähigen Schichten 2 können als Leiterbahnen 5 in den Ausnehmungen 4,6,7 angeordnet sein, wobei die Isolierung 3 dafür sorgt, daß die leitfähigen Schichten 2 gleicher Polarität miteinander verbunden werden (Figur 2). Ferner ist die Isolierung 3 so gestaltet, daß elektrische Durchschläge vermieden werden. In den halbkreis- und kreisförmigen Ausnehmungen 4,6 können die Leiterbahnen 5 für die Stromzuführung raumsparend untergebracht werden. Die Pfeile deuten die Polarisationsrichtung der einzelnen Scheiben 1 an.

## Patentansprüche

1. Aktuator aus ferroelektrischen Keramikscheiben, bei dem die beidseitig mit einer elektrisch leitfähigen Schicht versehenen Keramikscheiben miteinander verklebt und mit elektrischen Zuleitungen verbunden sind, dadurch gekennzeichnet, daß die leitfähigen Schichten (2) der einzelnen Scheiben (1) auf der Vorder- und Rückseite der Scheiben (1) mit jeweils einer um 180° gegeneinander versetzt angeordneten Isolierung (3) als Randzone versehen sind, wobei die Isolierungen (3) benachbarter Scheiben (1) übereinander liegen und den Isolierungen (3) auf der einen Seite bis auf die Kante reichende leitfähige Schichten (2) (Elektroden) auf der anderen Seite der Scheibe gegenüberliegen.

2. Aktuator nach Anspruch 1, dadurch gekennzeichnet, daß die Keramikscheiben im Bereich der Isolierungen (3) mit Ausnehmungen (4,6, 7) versehen sind.

3. Aktuator nach Anspruch 2, dadurch gekennzeichnet, daß die Ausnehmungen (4) halbkreisförmig ausgebildet sind und die Isolierung (3) konzentrisch um die Ausnehmung (4) angeordnet ist.
